# DEMANDE DE BREVET EUROPEEN

(11) **EP 2 960 956 A1**
(43) Date de publication de la demande: **30.12.2015**
(21) Numéro de dépôt: 15173516.4
(22) Date de dépôt: 24.06.2015
(51) Int. Cl.: H01L 51/00, H01L 51/42

(54) **PROCÉDÉ DE RÉALISATION D'UN FILM ORGANIQUE SEMI-CONDUCTEUR**

(30) Priorité: 24.06.2014 FR 1455832
(71) Demandeur: Armor, 44100 Nantes (FR)
(72) Inventeur: GUICHARD, Pierre Jean Yves, 44400 Rezé (FR); DERENNES, Christophe, 44310 Saint Philbert de Grand Lieu (FR)
(74) Mandataire: Blot, Philippe Robert Emile

(57) **Abrégé**

L'invention concerne un procédé de réalisation d'un film organique semi-conducteur comprenant les étapes de :
- préparation d'un premier mélange comprenant un premier matériau semi-conducteur organique de type p présentant une masse molaire inférieure ou égale à 2000 grammes.mol⁻¹ (g.mol⁻¹) et un premier matériau semi-conducteur organique de type n présentant une masse molaire inférieure ou égale à 2000 grammes.mol⁻¹ (g.mol⁻¹),
- ajout au premier mélange d'un deuxième matériau semi-conducteur organique pour former un deuxième mélange, le deuxième matériau étant un polymère présentant une masse molaire supérieure ou égale à 10000 g.mol⁻¹, et
- formation du film organique à partir du deuxième mélange.

## Description

La présente invention concerne un procédé de réalisation d'un film organique, une utilisation d'un film organique obtenu par mise en oeuvre du procédé de réalisation, une cellule photovoltaïque comportant une couche active enduite par le film organique, un module photovoltaïque composé de cellules photovoltaïques et un procédé de fabrication de la couche active d'une cellule photovoltaïque d'un module photovoltaïque.

Une cellule photovoltaïque est un composant électronique qui, exposé à la lumière (photons), produit de l'électricité grâce à l'effet photovoltaïque qui est à l'origine du phénomène. Le courant obtenu est lié à la puissance lumineuse incidente. La cellule photovoltaïque délivre une tension continue.

Une cellule photovoltaïque organique est une cellule photovoltaïque particulière. Dans ce cas, au moins la couche active est constituée de molécules organiques. De ce fait, l'effet photovoltaïque est, pour une cellule photovoltaïque, obtenu à l'aide des propriétés de matériaux semi-conducteurs.

Il est entendu par l'expression « semi-conducteur » un matériau qui a les caractéristiques électriques d'un isolant, mais pour lequel la probabilité qu'un électron puisse contribuer à un courant électrique, quoique faible, est non négligeable. En d'autres termes, la conductivité électrique d'un semi-conducteur est intermédiaire entre la conductivité électrique des métaux et la conductivité électrique des isolants.

Le comportement des semi-conducteurs est décrit par la physique quantique en utilisant une approximation par la théorie des bandes. L'approximation par la théorie des bandes stipule qu'un électron dans un semi-conducteur ne peut que prendre des valeurs d'énergie comprises dans des intervalles continus nommés « bandes », plus spécifiquement bandes permises, lesquelles sont séparées par d'autres « bandes » appelées bandes d'énergie interdites ou bandes interdites.

Deux bandes d'énergie permises jouent un rôle particulier : la dernière bande complètement remplie, appelée « bande de valence » et la bande d'énergie permise suivante appelée « bande de conduction ». Dans un semi-conducteur, comme dans un isolant, la bande de valence et la bande de conduction sont séparées par une bande interdite, appelée couramment par son équivalent anglais plus court « gap ». L'unique différence entre un semi-conducteur et un isolant est la largeur de cette bande interdite, largeur qui donne à chacun ses propriétés respectives. La largeur de la bande interdite est souvent caractérisée en énergie, cette énergie correspondant à l'énergie à fournir à un électron pour que l'électron passe de la bande de valence à la bande de conduction.

Un semi-conducteur est un semi-conducteur de type p lorsque le semi-conducteur comprend des éléments chimiques de valence différente de la valence des atomes du semi-conducteur et augmentant la concentration en trous dans la bande de valence. Un tel semi-conducteur est également appelé semi-conducteur dopé P ou donneur d'électrons.

Un semi-conducteur est un semi-conducteur de type n lorsque le matériau comprend des éléments chimiques de valence différente de la valence des atomes du semi-conducteur et augmentant la concentration en trous dans la bande de conduction. Un tel semi-conducteur est également appelé semi-conducteur dopé N ou accepteur d'électrons.

En outre, un semi-conducteur est considéré comme organique dès lors que le semi-conducteur comprend au moins une liaison faisant partie du groupe constitué par les liaisons covalentes entre un atome de carbone et un atome d'hydrogène, les liaisons covalentes entre un atome de carbone et un atome d'azote, ou encore des liaisons entre un atome de carbone et un atome d'oxygène.

De plus, dans le cas d'un semi-conducteur organique, l'approximation par la théorie des bandes n'est plus valable mais par analogie, des orbitales moléculaires ont le même comportement, l'orbitale HO correspondant à la bande de valence et l'orbitale BV à la bande de conduction. L'orbitale HO (acronyme pour « haute occupée ») est aussi désignée sous la terminologie anglaise d'orbitale HOMO (acronyme anglais de « highest occupied molecular orbital ») et désigne l'orbitale moléculaire la plus haute en énergie occupée par au moins un électron. L'orbitale BV (acronyme pour « basse vacante») est aussi désignée sous la terminologie anglaise d'orbitale LUMO (acronyme anglais de « lowest unoccupied molecular orbital») et désigne l'orbitale la plus basse en énergie non occupée par un électron.

Ainsi, les matériaux semi-conducteurs organiques présentent une bande interdite dont la largeur délimite le minimum d'énergie à fournir à un électron pour passer d'un état fondamental à un état excité. L'énergie est, par exemple fournie sous forme d'énergie lumineuse. Une telle cellule photovoltaïque est souvent désignée par son acronyme anglais OPV pour « Organic PhotoVoltaic ».

La cellule photovoltaïque organique comprend ainsi une couche active. La couche active possède une structure d'hétérojonction obtenue par un mélange, dans la masse, d'un matériau donneur d'électrons et d'un matériau accepteur d'électrons. Dans ce contexte, un matériau donneur d'électrons est un matériau semi-conducteur de type p tandis qu'un matériau accepteur d'électrons est un matériau semi-conducteur de type n.

Un film est une couche, homogène et continue, faite en un matériau ou mélange de matériaux présentant une épaisseur relativement faible. Il est entendu par une épaisseur relativement faible, une épaisseur inférieure ou égale à 500 microns.

Un film peut aussi être caractérisé par son homogénéité et notamment l'homogénéité de son épaisseur sur toute sa surface, son aspect (la présence de point de démouillage, de gradient de séchage, et autres défauts), sa rugosité et la résolution des bordures du film (ou contours du film).

De manière générale, les caractéristiques d'un film dépendent de plusieurs type de facteurs liés à : la technique utilisée pour la formation du film ; la solution déposée (la quantité déposée, sa mouillabilité sur le support, sa viscosité) ; aux matériaux utilisés (leurs concentrations leurs ratios et leurs solubilités dans le solvant, leurs masses molaires).

Un film peut être formé grâce à une large gamme de techniques qui peuvent être utilisées pour former les différentes couches d'une cellule photovoltaïque organique telles que les procédés d'impression (flexographie, héliographie, héliogravure, offset, jet d'encre...) et d'enduction (slot-die, curtain coating, knife coating, ...).

La technique de dépôt centrifuge est la plus utilisée pour étudier les caractéristiques des cellules photovoltaïques organiques. Le dépôt centrifuge aussi appelée dépôt à la tournette (plus connue sous son nom anglais de spin coating) est une méthode très répandue de déposition de couche mince sur une surface plane. Cette méthode consiste à déposer une goutte sur un plateau tournant, la goutte s'étalant alors par centrifugation, pour former une couche.

L'épaisseur de film formé dépend de facteurs liés à la manière dont la méthode est mise en oeuvre comme la vitesse angulaire (plus elle est grande, plus l'épaisseur sera fine), l'accélération (plus elle est grande, plus l'épaisseur sera fine) ou le temps de l'opération (plus l'opération est longue, plus le film formé est fin dans une moindre mesure).

De manière alternative, une méthode de dip-coating peut être utilisée pour former le film. Cette technique s'appuie sur un principe similaire à l'enduction centrifuge. Mais, dans ce cas, le substrat est trempé dans la solution et il est retiré avec une vitesse et un angle contrôlés.

En variante, une autre méthode dite de « doctor blading » est employable. Selon ce procédé, une lame de rasoir subit une translation à une distance définie du substrat dans le but d'étaler le matériau organique. Le volume déposé, la vitesse de translation et la hauteur de la lame permettent de définir l'épaisseur finale du film.

Ces méthodes de fabrication ne sont cependant pas compatibles avec la production à grande échelle qui devra de préférence être réalisée grâce à des procédés continus tels que les procédés au déroulé plus connus sous le nom anglais de roll-to-roll (noté R2R dans la suite de la description).

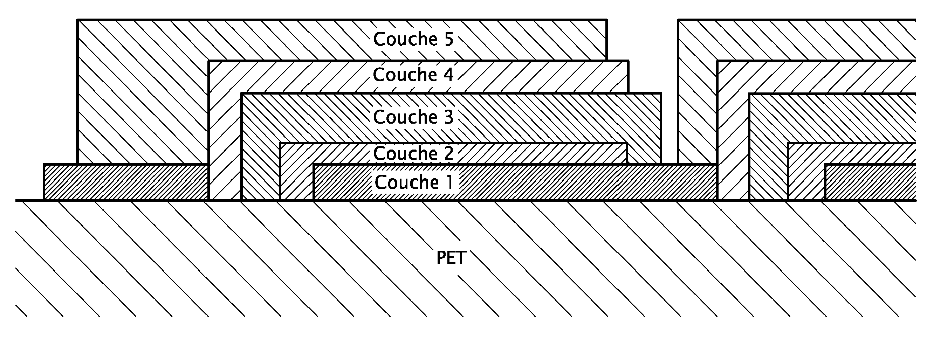

D'autre part, la fabrication de module photovoltaïque requiert le respect d'un certain nombre de conditions. Un module photovoltaïque organique est un ensemble comprenant au moins deux cellules photovoltaïque individualisées voisines les unes des autres et connectées en série ou en parallèle. La formation d'un module photovoltaïque organique nécessite le dépôt de motifs de bandes de film superposées sur un support, par exemple les bandes d'une largeur comprise entre 9,5 mm et 13,5 mm doivent être séparées d'une zone interbandes d'une largeur comprise entre 0,5 mm et 4,5 mm, la largeur totale de la bande et de la zone interbandes étant de 14 mm. Un module est constitué du dépôt de plusieurs couches par différentes méthodes d'enduction ou d'impression comme illustré sur la Figure qui est une vue en coupe d'un module photovoltaïque organique.

Parmi les conditions à respecter, il peut être cité une conception, une structuration, une géométrie exacte au millimètre près, des cellules photovoltaïques au niveau de la zone intermédiaire entre chaque cellule où celles-ci sont reliées électriquement les unes aux autres, la plupart des techniques de dépôt sont inappropriées car incompatibles avec la formation de motifs de bandes.

Les procédés R2R de dépôt à l'état liquide sont divisés en différentes catégories : les méthodes d'impression permettant de créer des motifs à haute résolution et les méthodes d'enduction résultant au dépôt de matière en pleine laize ou pleine surface sans motif.

Les méthodes envisagées pour la fabrication industrielle de modules grandes surfaces sont donc des techniques d'impression telles que la sérigraphie, la flexographie ou le dépôt par jet d'encre ou les méthodes d'enduction prédosées telles que les méthodes dites Slot-Die , Slide coating et Curtain coating (compatible avec les têtes d'enduction plus complexes permettant le design de bande de film). De telles méthodes sont notamment décrites dans l'article de Roar Sondergaard et al. intitulé « Roll-to-roll fabrication of polymer solar cells » publié dans la revue Materials today de janvier - février 2012, volume 15, numéro 1-2.

Chacune des méthodes d'enduction et/ou d'impression fonctionne mieux pour des viscosités spécifiques, la plupart des méthodes d'impression exigeant des encres de haute viscosité. Des encres parfaitement optimisées pourront produire des résolutions et des spécificités recherchées telles les exemples décrits dans l'article de Christoph Brabec et al. intitulé «Solution-Processed Organic Solar Cells » publié dans la revue Materials Research Society Bulletin de Juillet 2008, volume 33.

L'objectif de notre recherche est le développement de modules photovoltaïques de faible coût, flexibles, grâce aux technologies d'enduction et/ou d'impression roll-to-roll. Afin d'atteindre ces objectifs, les encres ayant les propriétés requises sont à formuler et la méthode de dépôt appropriée pour cette encre est à choisir. L'influence des paramètres du procédé sur les propriétés de la couche est à déterminer. L'influence des conditions de séchage sur les propriétés de la couche, comme la morphologie et l'uniformité, est à analyser.

La couche active est enduite/imprimée à partir d'un mélange de matériaux en solution dont la viscosité, la mouillabilité de la solution sur le support sont des paramètres à maitriser en fonction des matériaux et des méthodes de revêtements utilisées. Parmi les mélanges en solution usuellement considérés pour la formation de la couche active d'une cellule photovoltaïque, le mélange du poly(3-hexylthiophène) aussi noté P3HT avec le [6,6]-phényl-C61-butanoate de méthyle aussi noté PCBM est souvent étudié. Le P3HT est le matériau semi-conducteur de type p et le PCBM est le matériau semi-conducteur de type n.

Le P3HT est un polymère conjugué qui montre des propriétés filmogènes intéressantes mais les polymères sont aussi généralement plus difficiles à synthétiser et à purifier que les petites molécules, limitant leur attrait dans le cadre industriel et leur utilisation à grande échelle.

Motivé par la reproductibilité de la synthèse des petites molécules, des groupes de recherche ont mené des études, présentées par exemple dans l'article de Bright Walker et al. « Small Molecule Solution-Processed Bulk Heterojunction Solar Cells » paru dans la revue Chemistry of Materials -volume 23, numéro 3*,* des matériaux donneurs moléculaires permettant de haute performance, notamment une forte absorption de la lumière, une bonne stabilité photochimique. Leurs structures relativement compactes comportant quelques étapes de synthèse simples en font des matériaux prometteurs pour la production de masse de modules photovoltaïques organiques.

Toutefois, lorsque deux matériaux à bas poids moléculaire sont déposés pour former une couche à hétérojonction, ces matériaux ne forment pas de réseaux interpénétrés comme observé avec les polymères. Les films obtenus à partir de tels matériaux sont difficiles à réaliser industriellement du fait notamment de leur relativement mauvaise solubilité ou mouillabilité.

Il existe donc un besoin pour un procédé de réalisation d'un film organique permettant d'obtenir un film organique présentant de meilleures propriétés, par exemple en termes d'homogénéité, de rugosité et de définition des contours.

A cet effet, il est proposé un procédé de réalisation d'un film organique semi-conducteur comprenant les étapes de préparation d'un premier mélange comprenant un premier matériau semi-conducteur organique de type p présentant une masse molaire inférieure ou égale à 2000 grammes.mol⁻¹ et un premier matériau semi-conducteur organique de type n présentant une masse molaire inférieure ou égale à 2000 grammes.mol⁻¹. Le procédé de réalisation comporte également une étape d'ajout au premier mélange d'un deuxième matériau semi-conducteur organique pour former un deuxième mélange, le deuxième matériau étant un polymère présentant une masse molaire supérieure ou égale à 10000 g.mol⁻¹, et une étape de formation du film organique à partir du deuxième mélange.

Suivant des modes de réalisation particuliers, le procédé de réalisation comprend une ou plusieurs des caractéristiques suivantes, prise(s) isolément ou suivant toute combinaison techniquement possible :
- le deuxième matériau est un polymère semi-conducteur organique de type n.
- dans le deuxième mélange, le rapport en masse entre le deuxième matériau semi-conducteur et le premier matériau semi-conducteur organique de type n est compris entre 0,8 et 1,2.
- le deuxième matériau est un polymère semi-conducteur organique de type p.
- dans le deuxième mélange, le rapport en masse entre le deuxième matériau semi-conducteur et le premier matériau semi-conducteur organique de type p est compris entre 0,8 et 1,2.
- dans le deuxième mélange, le rapport en masse entre d'une part l'ensemble du deuxième matériau et du premier matériau semi-conducteur organique de type n et d'autre part le matériau semi-conducteur organique de type p est compris entre 0,8 et 1,2.
- à l'étape de préparation, le premier mélange comporte également un solvant ou un mélange de solvants.
- le deuxième mélange est plus soluble que le premier mélange.- le deuxième mélange a une viscosité supérieure à 2 mPa.s, de préférence supérieure à 3 mPa.s.
- l'étape de formation est mise en oeuvre par utilisation de l'une des techniques suivantes :
   o une technique d'enduction ou d'impression,
   o une technique d'enduction ou d'impression au déroulé dite Roll-to-Roll,
   o une technique d'enduction Slot-Die,- une méthode de sérigraphie,
   o une méthode de flexographie, et
   o une méthode par jet d'encre.

Il est aussi proposé l'utilisation du procédé de film organique semi-conducteur tel que précédemment décrit pour réaliser des bandes de film organique semi-conducteur.

Il est aussi proposé un film organique réalisé à partir du procédé de réalisation tel que décrit précédemment.

Il est également proposé une cellule photovoltaïque organique comportant une couche active réalisée par enduction d'un film organique tel que décrit précédemment.

Il est également proposé un module photovoltaïque organique comportant une cellule réalisée par enduction d'un film organique tel que décrit précédemment.

Il est aussi proposé un procédé de fabrication d'une couche active d'une cellule photovoltaïque organique d'un module photovoltaïque comprenant les étapes de fourniture d'un substrat, et d'enduction du substrat avec des bandes de film organique obtenue par l'utilisation telle que décrite précédemment.

Il est proposé un procédé de réalisation d'un film organique semi-conducteur.

Le procédé de réalisation comporte une étape de préparation d'un premier mélange.

Le premier mélange comporte un matériau semi-conducteur organique de type p et un premier matériau semi-conducteur organique de type n.

Le premier matériau semi-conducteur organique de type n présente une masse molaire inférieure ou égale à 2000 g.mol⁻¹.

Avantageusement, le matériau semi-conducteur de type n est choisi dans la liste constituée :
- du fullerène,
- du [6,6]-phényl-C61-butyrate de méthyle (aussi noté PC60BM),
- du [6,6]-phényl C61-butyrique acide méthyl ester (C60-PCBM),
- du [6,6]-phényl C71-butyrique acide méthyl ester (C70-PCBM),
- du bis(1-[3-(methoxycarbonyle)propyle]-1-phényl)[6.6]C62 (Bis-C60-PCBM),
- du 3'Phenyle-3'H-cyclopropa[8,25][5,6]fullerène-C70-bis-D5h(6)-3'butanoïque acide méthyl ester (Bis-C70-PCBM),
- de l'indène-C60-bisadduct (ICBA) et
- du mono indène nil C60 (ICMA).

De préférence, le matériau semi-conducteur de type n est du PC60BM.

Le premier matériau semi-conducteur organique de type p présente une masse molaire inférieure ou égale à 2000 g.mol⁻¹.

Avantageusement, le premier matériau semi-conducteur organique de type p est choisi dans la liste constituée du DTS-(FBTTH2)2, de l'IBTP, de l'IDF, t du DTS-(PTTH2), du boro-dipyrométhène, du dikétopyrrolopyrrole, de l'oligotiophène, de l'indigo, du quinacridone, de la mérocyanine, de la squaraine et des composés dits « push-pull ». Un composé dit « push-pull » est un assemblage d'un groupement dit push avec un groupement dit pull via une liaison π. Un groupement carbazole ou un groupement triphenylamine sont des exemples de groupement dit push. Un groupement dicyanovinylène ou benzothiadiazole sont des exemples de groupement dit pull. La liaison π est par exemple mise en oeuvre à l'aide d'un thiophène, d'un phényl ou d'un vinyl. Le composé dithiénosilole est un exemple de composé dit « push-pull ».

Selon un mode de réalisation préféré, le premier matériau semi-conducteur organique de type p est du DTS-(FBTTH2)2.

De préférence, le premier mélange est préparé en présence d'un solvant.

Avantageusement, le solvant est non halogéné.

Avantageusement, le solvant est non chloré.

Préférentiellement, le solvant est non toxique.

De préférence, le solvant est compatible avec l'emploi d'un séchoir thermique, c'est-à-dire que le point d'auto-inflammation est supérieur à 200°C Cela permet d'envisager l'emploi du solvant dans un contexte industriel, dans le respect de la santé des collaborateurs et de l'Environnement.

A titre d'exemple, le solvant est choisi dans une liste constituée du Diméthyl Sulfoxide (aussi noté DMSO), de l'acétone, du tétrahydrofurane (aussi noté THF), du méthyl éthyl cétone (aussi noté MEK), du toluène, du propylène glycol, du cyclohexane, du 2-butanol, du cyclohexanone, du 2-propanol, du méthylisobutylcétone (aussi noté MIBK), de l'acétophénone, du méthyl isopropyl cétone, du diméthyl éthanolamine, du méthyl n-propyl cétone, du éthylène glycol, del'o-xylène, du 1-méthyl-naphthalène, du 3-méthylthiophène, du nonane, de l'anisole, de l'éthylcyclohexane, du 2-éthyl-hexanol, de l'indane, du dodécane, du 1,2-hexanediol, du 1-butanol, du thiodiéthylène glycol, du diméthyl glutarate, du diméthyl succinate, de l'éthylène glycol diacétate, du dipropylène glycol monométhyl éther, du diéthylène glycol, du méthyl cyclohexane, du mésitylène, de l'aniline, du benzaldéhyde, de l'acétonitrile, du p-xylène ou du m-xylène.

A l'issue de la mise en oeuvre de l'étape de préparation, il est obtenu un premier mélange comportant le matériau semi-conducteur organique de type n et le matériau semi-conducteur organique de type p.

Le procédé de réalisation comporte également une étape d'ajout au premier mélange d'un polymère pour former un deuxième mélange.

Un polymère est une chaîne constituée d'un certain nombre de motifs monomères qui sont répétés.

Selon un mode de réalisation, le polymère est un polymère semi-conducteur organique de type p.

Selon un autre mode de réalisation, le polymère est un polymère semi-conducteur organique de type n.

Dans la suite, le deuxième matériau semi-conducteur organique est simplement désigné sous l'appellation « polymère ».

Le deuxième matériau semi-conducteur est un matériau photoactif.

Le polymère présente une masse molaire supérieure ou égale à 10000 g.mol⁻¹

Avantageusement, le polymère semi-conducteur organique de type p est choisi dans la liste constituée du polythiophène, du poly(alkyl-3 thiophène) dans lequel le groupe alkyle est de 6 à 16 atomes de carbone, du poly(3-hexylthiophène) (aussi noté P3HT), du poly[N-9'-heptadecanyl-2,7-carbazole-alt-5,5-(4,7-di-2-thienyl-2',1',3'-benzothiadiazole] (aussi noté PCDTBT), du poly(p-phénylène-vinylène) (aussi noté PPV), et les dérivés alcoxy du poly(p-phénylène-vinylène), du poly[2-méthoxy-5-(3,7-diméthyloctyloxy)-1,4-phénylène-vinylène] (aussi noté MDMO-PPV), du poly[2-méthoxy-5-(2-éthyl-hexyloxy)-1,4-phénylène-vinylène] (aussi noté MEH-PPV), du poly (2,5- diméthoxy-p-phénylène-vinylène) (aussi noté PDMPV), du poly(3,4-éthylènedioxythiophène) (aussi noté PEDOT) et du poly(3,4-éthylènedioxythiophène) : poly(styrène sulfonate) (aussi noté PEDOT:PSS), du polyacétylène, du polyphénylène, du poly[2,6-(4,4-bis-(2-éthylhexyle)-4H -cyclopenta[2,1-b;3,4-b'] - dithiophène)- ait -4,7-(2,1,3-benzothiadiazole)] (aussi noté PCPDTBT), du polyphénylacétylène, du polydiphénylacétylène, de la polyaniline, du polythiophène, du poly(thiénylènevinylène), du poly (2,5- thiénylènevinylène), du polyfluorène, des macrocycles porphyriniques, des polyporphyrines dérivées en thiol, du polymétallocène, du polyferrocène, du polyphtalocyanine, du polyvinylène, du polyphénylvinylène, du polysilane, du polyisothianaphthalène, du polythiénylvinylène, des dérivés de n'importe lequel des matériaux de la liste ou une combinaison des matériaux de la liste. A titre d'exemple de dérivés, les matériaux de la liste comprennent des groupes pendants, comme un éther cyclique, de l'époxy, de l'oxétane, du furane ou de l'oxyde de cyclohexène.

Optionnellement, les polymères précités sont des polymères conjugués.

En variante, les dérivés des matériaux précités incluent en variante ou additionnellement d'autres substituants. Par exemple, les groupes thiophènes compris dans les matériaux précités peuvent comprendre un groupe phényle ou un groupe alkyle, par exemple en position 3 du noyau thiophène. Des exemples de tels thiophènes sont des thiophènes tels que R3 est un groupe alkyle en C1- C8 ou un groupe alkyle en C1 - C6 alkyl- C ( = O) -O- alkyle en C1- C6. Le poly[3 - (éthyl-4- butanoate) thiophène- 2 ,5-diyle] est un exemple de tel thiophène. Comme autre exemple, un groupe alkyle, alcoxy, cyano, amino, et/ou des groupes substituants hydroxy peuvent être présents dans n'importe lequel du polyphénylacétylène, du polydiphénylacétylène, du polythiophène et du poly(p-phénylène-vinylène).

Selon un autre mode de réalisation, le polymère est du carbazole.

De préférence, le polymère est du P3HT, du PCDTBT ou du PTB7.

Selon un autre mode de réalisation, le polymère semi-conducteur organique de type n est choisi comme décrit dans l'article Facchetti, Antonio. "Polymer donor-polymer acceptor (all-polymer) solar cells" Materials Today 16, no. 4 (2013): 123-132.

A l'issue de la mise en oeuvre de l'étape d'ajout, il est obtenu un deuxième mélange comportant le premier matériau semi-conducteur organique de type n, le premier matériau semi-conducteur organique de type p et un polymère semi-conducteur organique.

Le deuxième mélange présente une meilleure solubilité que le premier mélange. La solubilité est une grandeur physique désignant la concentration molaire maximale du soluté dans le solvant, à une température donnée. La solution ainsi obtenue est alors saturée. La solubilité est mesurée en saturant la formulation, centrifugeant et prélevant le surnageant et mesurant l'absorbance de la formulation au spectrophotomètre dont on déduit la concentration

Les matériaux sont introduits à saturation dans le(s) solvant(s) et mis sous agitation à 50°C à 900rpm pendant 24h. Les volumes de tests seront fixés à 2 mL.

Les mélanges sont ensuite centrifugés afin de récupérer le surnageant contenant le(s) matériau(x) qui a (ont) été solubilisé(s). Le surnageant est alors analysé après dilution par spectroscopie UV-Vis afin de déterminer la concentration du matériau solubilisé dans le solvant.

La concentration limite de matériaux dans le premier mélange est donc inférieure à la concentration de matériaux dans le deuxième mélange. L'ajout du matériau pour constituer le deuxième mélange permet d'augmenter la solubilité du deuxième mélange et de disposer, pour un même volume, de plus de matériaux actifs tout en présentant de meilleures performances en terme d'enduction (mouillabilité, rugosité et homogénéité des films) comme présenté dans le tableau « Observation de la qualité de l'enduction ».

Le deuxième mélange présente une viscosité plus élevée que les mélanges de l'état de la technique.

Le procédé de réalisation comporte également une étape de formation du film organique à partir du deuxième mélange.

De préférence, l'étape de formation est mise en oeuvre par utilisation d'une technique d'enduction ou d'impression au déroulé.

En variante, l'étape de formation est mise en oeuvre par utilisation d'une technique d'enduction Slot-Die.

Selon une autre variante, l'étape de formation est mise en oeuvre par une méthode de sérigraphie, une méthode de flexographie ou un méthode de jet d'encre.

A l'issue de l'étape de formation, il est obtenu un film.

Le film obtenu à l'issue de l'étape de formation présente de meilleures propriétés en termes d'homogénéité, de rugosité et de définition des bords.

Le film obtenu présente également une homogénéité améliorée, résultant en une meilleure structure interne, une meilleure morphologie et une meilleure qualité d'interface avec les éventuelles autres couches avec lequel le film aura à interagir.

En outre, le film présente un spectre d'absorption plus large de la lumière incidente.

En outre, l'obtention du film n'implique pas l'utilisation de solvants toxiques ou nocifs.

Le film est donc particulièrement adapté pour obtenir une couche active de cellule photovoltaïque présentant des propriétés améliorées. Le film est également utilisable pour réaliser des diodes électroluminescentes organiques (aussi appelées oled) ou des photodiodes.

De préférence, le deuxième mélange consiste en un matériau semi-conducteur organique de type n, un matériau semi-conducteur organique de type p et le polymère.

Avantageusement le polymère est un polymère semi-conducteur de type p ou de type n.

Avantageusement, dans le deuxième mélange, le rapport en masse entre le polymère et le matériau semi-conducteur organique de même type est compris entre 0,8 et 1,2. Dans toute la suite de la description, il est entendu par l'expression compris entre X et Y que la quantité considérée est d'une part supérieure ou égale à X et d'autre part inférieure ou égale à Y.

De préférence, dans le deuxième mélange, le rapport en masse entre le polymère et le premier matériau semi-conducteur organique de même type est compris entre 0,9 et 1,1.

De préférence, dans le deuxième mélange, le rapport en masse entre le polymère et le premier matériau semi-conducteur organique de même type est égal à 1,0.

Avantageusement, dans le deuxième mélange, le rapport en masse entre d'une part l'ensemble du polymère et du premier matériau semi-conducteur organique de type p et d'autre part le matériau semi-conducteur organique de type n est compris entre 0,8 et 2.

De préférence, dans le deuxième mélange, le rapport en masse entre d'une part l'ensemble du polymère et du premier matériau semi-conducteur organique de type p et d'autre part le matériau semi-conducteur organique de type n est compris entre 0,9 et 1,5.

De préférence, dans le deuxième mélange, le rapport en masse entre d'une part l'ensemble du polymère et du premier matériau semi-conducteur organique de type p et d'autre part le matériau semi-conducteur organique de type n est égal à 1,0.

Selon une variante, le deuxième mélange comporte un solvant ou un mélange de solvant, le solvant étant un mélange de deux composés.

Avantageusement, l'absorption d'au moins l'un parmi le polymère semi-conducteur organique et le premier matériau semi-conducteur organique de même type est supérieure de 10% pour une onde lumineuse incidente ayant une longueur d'onde comprise entre 300 nm et 800 nm.

Cela permet d'améliorer l'absorption du mélange sur une longueur d'onde comprise entre 250 nm et 600 nm. Il en résulte que le mélange présente un spectre d'absorption plus large que le spectre d'absorption du polymère semi-conducteur organique seul ou du premier matériau semi-conducteur organique de même type seul.

De préférence, l'absorption d'au moins l'un parmi le polymère semi-conducteur organique et le premier matériau semi-conducteur organique de même type est supérieure de 10% pour une onde lumineuse incidente ayant une longueur d'onde comprise entre 300 nm et 600 nm.

Cela permet d'améliorer l'absorption du deuxième mélange sur une longueur d'onde comprise entre 100 nm et 600 nm. Il en résulte que le deuxième mélange présente un spectre d'absorption plus large que le spectre d'absorption du polymère semi-conducteur organique seul ou du premier matériau semi-conducteur organique de même type seul.

Ainsi, le procédé précédemment décrit permet la résolution d'une contradiction technique qui est d'atteindre des paramètres de processabilité industriellement viables :
- reproductibilité des formulations (propriétés des petites molécules contrairement au polymère qui présente beaucoup de variabilité - longueur de chaine-entrainant des propriétés instables) en effet la longueur des chaines et la variabilité de masse molaire des polymères amène en effet des propriétés instables de lot à lot.
- filmogénéïté des formulations destinées à être enduites par des procédés industriels dits au déroulé. Cette propriété est intrinsèque à la nature des polymères. Cette propriété peut être ajustée au cours des étapes de formulation des polymères. La viscosité permet d'obtenir des contours nets nécessaires à la fabrication de modules.

Ces deux contraintes sont remplies tout en conservant des propriétés photoactives optimales pour produire des dispositifs photovoltaïques électriquement performants et donc économiquement viables.

L'ajout du polymère semi-conducteur photoactif a permis de résoudre ce problème contradictoire en améliorant la filmogénéité d'une formulation à base de petites molécules tout en conservant et même améliorant les propriétés photoactives du film.

En effet, l'ajout de polymère isolant tel que le polystyrène permet de modifier les propriétés mécaniques d'une formulation cependant cet ajout impacte aussi les propriétés électriques du mélange. En effet, l'ajout d'un matériau pour former un deuxième mélange entraîne la réorganisation du réseau donneur/accepteur à l'origine de l'extraction des charges.

Les propriétés de transport de charge des polymères semi-conducteurs sont supérieures aux propriétés de transport d'un polymère isolant comme le polystryrène, mais la modification de l'équilibre du premier mélange peut conduire à une variété de modifications morphologiques et la réorganisation des réseaux donneur/accepteur et leurs propriétés électriques sont très difficiles à prévoir.

Il a en fait été observé une amélioration de la solubilité du deuxième mélange : il n'était pas attendu que l'ajout d'un polymère semi-conducteur photoactif entrainerait une amélioration de la solubilité et permettrait l'addition de matériau ayant pour conséquence une potentielle augmentation de l'extraction des charges.

D'autre part, les polymères semi-conducteurs photoactifs présentent des structures moléculaires complexes, notamment avec des chaînes latérales plus ou moins longues, qui affectent aussi leur solubilité et filmogénéité (les paramètres de Hansen expliquent la difficulté de solubilisation des polymères photoactifs, pour plus de détails concernant les paramètres de Hansen, on pourra se reporter à "Solubility parameters", Charles M. Hansen, Alan Beerbower, Kirk Othmer, supplement volume, pp. 889 à 8902e édition 1971; C. M. Hansen, Hansen Solubility Parameters: A User's Handbook, CRC Press, Boca Raton, FL 2000 ; et A. F. M. Barton, CRC handbook of solubility parameters and other cohesion parameters 2nd ed., CRC Press, Boca Raton, FL 1991. Les interactions moléculaires entre les chaînes polymères, et donc la cohésion intermoléculaire expliquent le degré de filmogénéité des polymères.

Il est donc étonnant que l'ajout d'un semi-conducteur photoactif permette d'ajuster la viscosité et de l'adapter aux spécifications des procédés d'enduction au déroulé.

La mise au point d'un procédé d'enduction industrialisable est bien l'objectif atteint avec le présent procédé. Cela implique l'usage de solvants non chlorés et de procédés au déroulé tel que listés dans la description qui sont fondamentalement différent des procédés d'enduction à la tournette utilisés dans les documents connus de l'état de la technique.

### Expériences

Les expériences sont menées pour un deuxième mélange dans lequel :
- le premier matériau est du DTS(FBTTH2)2 le polymère est du P3HT, et
- le matériau semi-conducteur organique de type p est du PCBM.

Dans les expériences mises en oeuvre, certains paramètres sont invariants :
- le ratio entre donneur et accepteur est un ratio massique de 1 pour 1 ;
- le ratio solvantaire est de 50% en masse d'o-xylène pour 50% en masse de 1-Méthyl Naphthalène (Mna);
- la concentration totale en donneur est de 20 g.L⁻¹, et
- la quantité de formulation est de 10 mL.

A contrario, d'autres paramètres sont variables dans les expériences suivantes, à savoir :
- la proportion massique relative en polymère, la proportion massique relative en polymère étant définie comme un rapport dont le numérateur est la masse du polymère dans le deuxième mélange et le dénominateur est la somme des masses du polymère et du premier matériau de même type dans le deuxième mélange, et
- la proportion massique en premier matériau, la proportion massique relative en premier matériau étant définie comme un rapport dont le numérateur est la masse du premier matériau dans le deuxième mélange et le dénominateur est la somme des masses du polymère et du premier matériau de même type dans le deuxième mélange.

Il est alors mis en oeuvre cinq expériences pour différentes proportions massiques relatives en polymère (respectivement en premier matériau):

| Expériences | Polymère (proportion massique relative en %) | Premier matériau (proportion massique relative en %) |
|---|---|---|
| 1 | 0 | 100 |
| 2 | 25 | 75 |
| 3 | 50 | 50 |
| 4 | 75 | 25 |
| 5 | 100 | 0 |

Pour chacune des expériences, la composition en masse du deuxième mélange est donc la suivante :

| Expériences | Premier matériau semi conducteur organique de type p | Premier matériau semi-conducteur organique de type n | Polymère semi conducteur organique de type p | o-xylène | 1-methylnaphtalène |
|---|---|---|---|---|---|
| 1 | 0,20 | 0,21 | 0,00 | 4,80 | 4,80 |
| 2 | 0,15 | 0,21 | 0,05 | 4,80 | 4,80 |
| 3 | 0,10 | 0,21 | 0,10 | 4,80 | 4,80 |
| 4 | 0,05 | 0,21 | 0,15 | 4,80 | 4,80 |
| 5 | 0,00 | 0,21 | 0,21 | 4,80 | 4,80 |

Pour chacune des expériences, le mode opératoire comprend les opérations suivantes :
1) pesée du matériau semi-conducteur organique de type n (PCBM) et des solvants dans des fioles en verre de 20 mL,
2) mélange du matériau semi-conducteur organique de type n et des solvants,
3) mise en agitation du mélange obtenu à l'issue de l'étape 2) à 900 tr/min pendant 3 heures à 60°C,
4) pesée et ajout du premier matériau de type p (DTS(FBTTH2)2),
5) préparation du premier mélange,
6) pesée et ajout du polymère semi-conducteur de type p (P3HT),
7) obtention du deuxième mélange,
8) mise en agitation du deuxième mélange à 900 tr/min pendant 18 heures à 60°C,
9) observation de la solubilité du deuxième mélange à l'oeil nu,
10) mesures rhéologiques mises oeuvre en conservant le deuxième mélange dans une étuve à 30°C, les mesures étant effectuées par un Rhéomètre RhéoStress, la viscosité étant analysée avec le cône C35/0,5°. La viscosité est mesurée pour plusieurs vitesses de rotation de l'appareil, à savoir 500 s⁻¹, 1 000 s⁻¹ ou 10 000 s⁻¹,
11) enduction du deuxième mélange sur de ITO et du PET à une température de 40°C et à une vitesse de 40 mm/s par utilisation d'un applicateur de film automatique ou doctor-blade muni d'une fente de 12,5 µm,
12) séchage mis en oeuvre à une température de 80°C,
13) observation à l'oeil nu de la qualité de l'enduction, et
14) mesure de l'absorbance de la couche sur un spectrophotomètre UV-Visible.

Le tableau suivant résume les résultats obtenus pour les caractéristiques relatives à la viscosité du deuxième mélange :

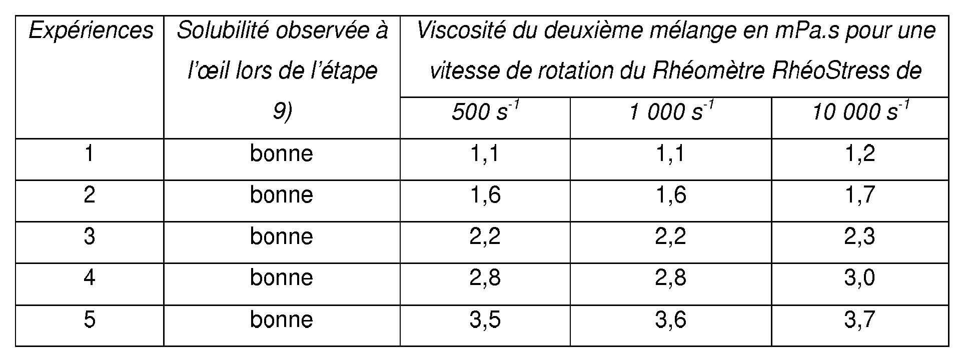

Il apparaît que les deuxièmes mélanges utilisant un solvant à base d'o-xylène/1-méthylnaphtalène présentent une très bonne solubilité.

Il est également observable que l'ajout du polymère fait augmenter la viscosité.

Le tableau suivant résume les résultats obtenus pour les propriétés relatives à l'enduction du deuxième mélange :

| *Expériences* | *Observations de la qualité de l'enduction* | |
|---|---|---|
| | *sur PET* | *sur ITO* |
| 1 | Enduction homogène | Enduction homogène |
| | Présence d'agglomérats | Présence de agglomérats |
| 2 | Enduction homogène | Enduction homogène, |
| | Quelques agglomérats | Quelques agglomérats |
| 3 | Enduction homogène | Enduction homogène |
| | Quelques agglomérats | Quelques agglomérats |
| 4 | Enduction homogène | Enduction homogène |
| | Quelques agglomérats | Quelques agglomérats |
| 5 | Enduction homogène | Enduction homogène |
| | Absence d'agglomérats | Absence d'agglomérats |

Il apparaît que les films obtenus à partir du premier mélange présentent le plus d'agglomérats dus à la faible solubilité des matériaux du premier mélange.

Il est également observable que la formulation à isomasse de premier matériau et de polymère correspond aux meilleures performances en terme d'enduction : mouillabilité des mélanges, rugosité et homogénéité des films.

## Revendications

1. Procédé de réalisation d'un film organique semi-conducteur comprenant les étapes de :
- préparation d'un premier mélange comprenant un premier matériau semi-conducteur organique de type p présentant une masse molaire inférieure ou égale à 2000 grammes.mol⁻¹ (g.mol⁻¹) et un premier matériau semi-conducteur organique de type n présentant une masse molaire inférieure ou égale à 2000 grammes.mol⁻¹ (g.mol⁻¹),
- ajout au premier mélange d'un deuxième matériau semi-conducteur organique pour former un deuxième mélange, le deuxième matériau étant un polymère présentant une masse molaire supérieure ou égale à 10000 g.mol⁻¹, et
- formation du film organique à partir du deuxième mélange.

2. Procédé selon la revendication 1, dans lequel le deuxième matériau est un polymère semi-conducteur organique de type n.

3. Procédé selon la revendication 2, dans lequel dans le deuxième mélange, le rapport en masse entre le deuxième matériau semi-conducteur et le premier matériau semi-conducteur organique de type n est compris entre 0,8 et 1,2.

4. Procédé selon la revendication 1, dans lequel le deuxième matériau est un polymère semi-conducteur organique de type p.

5. Procédé selon la revendication 4, dans lequel dans le deuxième mélange, le rapport en masse entre le deuxième matériau semi-conducteur et le premier matériau semi-conducteur organique de type p est compris entre 0,8 et 1,2.

6. Procédé selon l'une quelconque des revendications 1 à 5, dans lequel dans le deuxième mélange, le rapport en masse entre d'une part l'ensemble du deuxième matériau et du premier matériau semi-conducteur organique de type n et d'autre part le matériau semi-conducteur organique de type p est compris entre 0,8 et 1,2.

7. Procédé selon l'une quelconque des revendications 1 à 6, dans lequel, à l'étape de préparation, le premier mélange comporte également un solvant ou un mélange de solvants.

8. Procédé selon l'une quelconque des revendications 1 à 7, dans lequel dans le deuxième mélange est plus soluble que le premier mélange.

9. Procédé selon l'une quelconque des revendications 1 à 8, dans lequel le deuxième mélange a une viscosité supérieure à 2 mPa.s, de préférence supérieure à 3 mPa.s.

10. Procédé selon l'une quelconque des revendications 1 à 9, dans lequel l'étape de formation est mise en oeuvre par utilisation de l'une des techniques suivantes :
- une technique d'enduction ou d'impression,
- une technique d'enduction ou d'impression au déroulé dite Roll-to-Roll,
- une technique d'enduction Slot-Die,- une méthode de sérigraphie,
- une méthode de flexographie, et
- une méthode par jet d'encre.

11. Utilisation du procédé de film organique semi-conducteur selon l'une quelconque des revendications de 1 à 10 pour réaliser des bandes de film organique semi-conducteur.

12. Film organique réalisé à partir du procédé de réalisation selon l'une quelconque des revendications 1 à 10.

13. Cellule photovoltaïque organique comportant une couche active réalisée par enduction d'un film organique selon la revendication 12.

14. Module photovoltaïque organique comportant une cellule réalisée par enduction d'un film organique selon la revendication 12.

15. Procédé de fabrication d'une couche active d'une cellule photovoltaïque organique d'un module photovoltaïque comprenant les étapes de :
- fourniture d'un substrat, et
- enduction du substrat avec des bandes de film organique obtenue par l'utilisation selon la revendication 11.
